# EUROPEAN PATENT SPECIFICATION

(11) **EP 4 105 168 B1**
(45) Date of publication and mention of the grant of the patent: **22.01.2025**
(21) Application number: 21180370.5
(22) Date of filing: 18.06.2021
(51) Int. Cl.: B81C 1/00, B81C 3/00, B81C 99/00

(54) **METHOD FOR FORMING A THREE-DIMENSIONAL VAN-DER-WAALS MULTILAYER STRUCTURE BY STACKING TWO-DIMENSIONAL LAYERS AND STRUCTURE FORMED BY THIS METHOD**
VERFAHREN ZUR HERSTELLUNG EINER DREIDIMENSIONALEN VAN-DER-WAALS-MEHRSCHICHTSTRUKTUR DURCH STAPELN VON ZWEIDIMENSIONALEN SCHICHTEN UND NACH DIESEM VERFAHREN HERGESTELLTE STRUKTUR
PROCÉDÉ DE FORMATION D'UNE STRUCTURE MULTICOUCHE TRIDIMENSIONNELLE VAN-DER-WAALS PAR EMPILEMENT DE COUCHES BIDIMENSIONNELLES ET STRUCTURE FORMÉE SELON CE PROCÉDÉ

(43) Date of publication of application: 21.12.2022
(73) Proprietor: Eberhard Karls Universität Tübingen, 72074 Tübingen (DE)
(72) Inventor: HAAS, Jonas, 72070 Tübingen (DE); MEYER, Jannik, 72116 Mössingen (DE)
(74) Representative: Ostertag & Partner Patentanwälte mbB

(56) References cited:
- WO-A1-2021/027816
- US-A1- 2020 048 082
- US-A1- 2020 083 037

## Description

The present invention relates to a method for forming three-dimensional (3D) multilayer structures by stacking two-dimensional (2D) layers, an apparatus for preparing such multilayer structures, multilayer structures obtained by the method and devices comprising such multilayer structures.

Structuring matter on the smallest dimensions is a key capability for many areas of technologies, most prominently for information processing but also e.g. for sensing, nanofluidics, optics, catalysis, medicine and many more. The feature sizes in information processing devices have continuously shrunk over many decades, now approaching limitations given by the granularity of the atomic structure. Methods for manufacturing arbitrary three-dimensional (3D) structures are commonly referred to as "3D printing". Also in this area, the minimum feature sizes that can be defined are continuously shrinking as new approaches are invented and developed, although the 3D resolution is still larger than what can be achieved in planar structures.

One outstanding approach for preparing structures of smallest dimension is the production of van-der-Waals heterostructures by assembling stacks of 2D materials. As described e.g. by Novoselov et al. (K. S. Novoselov, D. Jiang, F. Schedin, T. J. Booth, V. V. Khotkevich, S. V. Morozov, and A. K. Geim, Two-dimensional atomic crystals, Proceedings of the National Academy of Sciences of the United States of America, 102(30): 10451-3, Jul 2005) 2D materials are isolated, one unit cell (or half a unit cell) thick layers, most of which can be described as an individual plane extracted from a van-der-Waals bonded layered material. Some of them are only one atom thick (e.g. graphene or single-layer hexagonal boron nitride), while many more examples can be given for structures with two, three or more atomic layers. Importantly, these layers can be assembled in any arbitrary sequence, yielding so-called van-der-Waals (vdW) heterostructures, as described e.g. by Geim and Grigorieva (A. K. Geim and I. V. Grigorieva, Van der Waals heterostructures, Nature, 499(7459): 419-425, Jul 2013). This allows combining unique properties of the constituents, and may also lead to entirely new features due to the interaction between the layers. As described e.g. by Dean et al. (C. R. Dean, L. Wang, P. Maher, C. Forsythe, F. Ghahari, Y. Gao, J. Katoch, M. Ishigami, P. Moon, M. Koshino, T. Taniguchi, K. Watanabe, K. L. Shepard, J. Hone, P. Kim, A. F. Young, I. Meric, C. Lee, L. Wang, S. Sorgenfrei, K. Watanabe, T. Taniguchi, P. Kim, K. L. Shepard, and J. Hone, Boron nitride substrates for high-quality graphene electronics, Nature Nanotechnology, 5(10): 722-726, Oct 2010), hexagonal boron nitride (hBN) is not only an excellent substrate for graphene, but can also have a profound influence on graphene's electronic properties that sensitively depends on the relative alignment of the sheets.

The assembly of conducting (e.g. graphene), insulating (e.g. hBN) and semiconducting layers (e.g. molybdenum disulfide - MoS₂) has led to a wide range of new device geometries such as transistors with ultra-thin gate dielectric, photo-transistors and photo-voltaic devices.

As reviewed by Novoselov et al. (K. S. Novoselov, A. Mishchenko, A. Carvalho, A. H. Castro Neto, 2D materials and van der Waals heterostructures, Science 353, aac9439, 2016) the presently most versatile technique for heterostructure assembly is direct mechanical assembly. In short, the technique comprises providing a flake of a 2D crystal on a sacrificial membrane. The 2D crystal together with the sacrificial membrane is aligned and placed on another flake of a 2D crystal. The sacrificial membrane is then removed. Thus, the sacrificial membrane is used as a carrier for the 2D crystal. For deposition of further layers the process is repeated. This process is also called pick-and-lift technique. The removal of the sacrificial membrane may be done by dissolution of the membrane by chemicals respectively solvents.

Also Guo et al. (A.-W. Guo, Z. Hu, Z.-B. Liu, J.-G. Tian, Stacking of 2D materials, Adv. Funct. Mater. 2021, 31, 2007810) review present assembly strategies in stacking of 2D materials. Compared with ordinary synthesis process, the stacking technique is a powerful strategy to achieve high-quality and freely controlled 2D material stacked structures with atomic accuracy. Moreover, it offers a perspective platform for the increasing application of 2D materials. As summarized by the authors, the mechanical stacking process may be divided into three steps: Step 1, preparation or transfer of the top 2D material onto a carrier; step 2, stacking of the top 2D material on a bottom 2D material or at a specific position; and step 3, carrier removal. The removal of the carrier may be done by dry or wet methods, e.g. by a chemical removal of the transfer carrier. Nevertheless, remaining residues of the carrier may heavily contaminate heterostructure devices. Thus, cleaning strategies are generally required for the surface of the stacked structure.

As described e.g. by Jessen et al. (Bjarke S. Jessen, Lene Gammelgaard, Morten R. Thomsen, David M. A. Mackenzie, Joachim D. Thomsen, José M. Caridad, Emil Duegaard, Kenji Watanabe, Takashi Taniguchi, Timothy J. Booth, Thomas G. Pedersen, Antti-Pekka Jauho, and Peter Bøggild, Lithographic band structure engineering of graphene, Nature Nanotechnology, 14(4): 340-346, Apr 2019) 2D materials can be structured by conventional lithographic techniques, after they are deposited on a substrate. Clark et at. (Nick Clark, Edward A. Lewis, Sarah J. Haigh, and Aravind Vijayaraghavan, Nanometre electron beam sculpting of suspended graphene and hexagonal boron nitride heterostructures, 2D Materials, 6(2): 025032, Mar 2019) describe the direct patterning of suspended membranes consisting of a graphene layer on top of a thin layer of hexagonal boron nitride which acts as a mechanical support, using a highly focused electron beam to fabricate structures with extremely high spatial resolution within the scanning transmission electron microscope (STEM).

US 2020/083037 A1 (D1) discloses van der Waals (VDW) films comprising one or more transition metal chalcogenide (TMD) films. Also provided are methods of making VDW films. The methods are based on transfer of monolayer TMD films under vacuum, for example, using a handle layer. Also provided are apparatuses and devices comprising one or more VDW film.

US 2020/0048082 A1 discloses a method of transferring a two-dimensional material such as graphene onto a target Substrate for use in the fabrication of micro- and nano-electromechanical Systems (MEMS and NEMS). The method includes providing the two-dimensional material in a first lower state of strain; and applying the two-dimensional material onto the target substrate whilst the two-dimensional material is under a second higher state of strain.

Nevertheless, the problem of formation of arbitrary 3D structures by the assembly of 2D material layers, especially patterned 2D material layers, is not really solved until today. Besides creating the desired pattern in each layer, one of the most important but unresolved issue is maintaining the accuracy of the lateral and/or vertical alignment of the layers during stacking.

Thus, there is a still a great need for techniques and methods for the assembly of van-der-Waals 3D multilayer structures, which allow a precise lateral alignment between the layers and which offer many possibilities for a wide variety of structuring with particularly high resolution within the multilayer structure.

This object is solved by a method as it is depicted in independent claim 1 and an apparatus for preparing van-der-Waals multilayer structures as it is depicted in independent claim 13. The van-der-Waals multilayer structures and devices as depicted in independent claims 14 and 15 are also part of the invention. Preferred embodiments of these aspects of the invention will become apparent from the dependent claims.

The method according to the invention is a method of forming a three-dimensional (3D) van-der-Waals multilayer structure by stacking two-dimensional (2D) layers. The method always comprises the following steps a. to g. :
a. Providing at least two of the 2D layers,
b. placing a first of the 2D layers onto a support,
c. placing a second of the 2D layers onto the previously placed first 2D layer, thereby producing a stack of two layers,
d. optionally, repeating step c. with one or more further of the 2D layers, thereby increasing the height of the stack,
e. The 2D layers are free-standing membranes,
f. the support comprises or is a target frame defining an opening, and
g. the free-standing membranes are placed in such a way that they span the opening of the target frame.

This proposed inventive method provides a completely new approach to stack 2D layers and fabricate a multilayer structure.

An important aspect of the invention is, that the inventors were able to demonstrate that it is possible to stack 2D layers as free-standing membranes, that is to say without the use of sacrificial membranes as known from the aforementioned pick-and-lift technique. According to this prior art technique the membranes are formed or placed on a carrier such that there is full contact between the membranes and the carrier. The side of a membrane with which it sticks to the carrier is supported by the carrier over its entire surface.

A further important aspect of the invention is, that the inventors were able to demonstrate that it is possible to produce stacks of pre-structured 2D layers. In this process, the 2D layers are structured in a first step and in a second step, the structured 2D layers are stacked to form a multilayer structure. The method according to the invention provides a platform that allows creation of e.g. heterostructures with a wide variety of properties.

A further important aspect of the invention is, that the inventors were able to demonstrate that structures in subsequent layers can be aligned with a lateral offset of less than 10 nm with the new assembly protocol. By the combination of arbitrary structures in each layer and the stacking with precise lateral alignment, it thus becomes possible to create almost arbitrary 3D structures. Moreover, as each layer can be chosen from the large zoo of 2D materials, the invention allows to directly generate a wide variety of functional devices.

In the context of the present invention the term "two-dimensional (2D)" is not to be understood in a mathematical meaning.

In the sense of the invention the term "two-dimensional" refers to a flat material layer which expands primarily in a plane. Of course, such a flat material layer has a certain thickness (third dimension), but the thickness of the 2D layers is very small, compared to their extent in the plane. Preferably, the 2D layers have a thickness of only one or a few (for example 2-10) atomic layers.

The term "three-dimensional van-der-Waals multilayer structure" refers to an assembly of stacked 2D layers, wherein the 2D layers are primarily bonded to each other by van-der-Waals forces, at least immediately after the placement of the layers. As it is widely known, van-der Waals forces are relatively weak, non-covalent and distance-depending interactions between atoms and/or molecules. After placement of the layers, however, it is also possible to reinforce the structural integrity of the stack by creating chemical bonds between neighboring layers.

The target frame with the opening, over which the free-standing membranes are placed, plays an important role in manufacturing of a 3D structure. On the one hand, as will be shown in the following, the target frame can serve as a template which defines the base area of the van-der-Waals multilayer structure. On the other hand, it provides adhesion to the first of the 2D layers which is required for placement of the first of the 2D layers on the support.

The target frame can be formed, for example, as a circumferential elevation on a flat support, which encloses the opening. The circumferential elevation basically may have any geometry. So, for example, it may be shaped as a circular ring or it may be shaped like a polygon, for example it may have a tetragonal, pentagonal or hexagonal geometry.

In a particularly preferred embodiment, the opening of the target frame may be a hole and the target frame itself may be a ring surrounding the hole. In a further particularly preferred embodiment, the opening of the target frame may be a through hole breaking through the support and the target frame itself may be a circumferential edge of the through hole.

The support itself may be a layer of a metal or of a metal alloy, preferably of a constant thickness.

In a preferred embodiment of the method according to the invention it comprises at least one of the following additional features a. to c., preferably all features a. to c.:
a. The support comprises the target frame with the opening as a first frame with a first opening.
b. The 2D layers are placed by means of at least one carrier frame defining a second opening.
c. The first opening is smaller than the second opening.

As mentioned above, the free-standing membranes which are used for the process according to the invention are, contrary to the techniques known from the prior art, not handled with the help of a carrier medium with which the membranes are in full contact. A preferred replacement for the full contact carrier medium is the at least one carrier frame. It is the preferred means to place the free-standing membranes on the support or on a previously placed membrane.

The at least one carrier frame may be shaped like the target frame. That is to say, that in a particularly preferred embodiment, the opening of the at least one carrier frame may be a hole or e.g. an indent and the carrier frame itself may be a ring surrounding the opening and in a further particularly preferred embodiment, the opening of the at least one carrier frame may be a through hole breaking through the support and the carrier frame itself may be a circumferential edge of the through hole. The ring or the edge may be shaped circular or oval. In other embodiments the ring or the edge may be shaped like a polygon, for example they may have a tetragonal, pentagonal or hexagonal geometry.

Basically, it is possible to use only one carrier frame for the placing of the membranes onto the support or onto previously placed membranes. However, it is also possible to use two or more carrier frames.

According to the invention, the openings of the frames allow a free-standing area of the 2D layer wherein the frames themselves provide a partial support for the 2D layers. The free-standing nature of the 2D layers enables various particularly advantageous embodiments of the method according to the invention which will be discussed in more detail below. For example, as a very important advantage, the use of free-standing 2D layers allows visual feedback throughout the whole assembly process especially by electron microscopy means. This is not possible in prior art assembly processes which employ the aforementioned full-surface contact transfer carriers. Moreover, the use of free-standing 2D layers allows a very precise and an individual pre-structuring of the 2D layers prior to stacking.

It is particularly advantageous if the first opening is smaller than second opening of the at least one carrier frame. This opening facilitates the placement of the free-standing membranes, otherwise it would be difficult to place the membranes such that they span the opening of the target frame.

In a preferred embodiment of the method according to the invention it comprises at least one of the following additional features:
a. The target frame comprises a contact zone surrounding its opening;
b. The contact zone surrounding the opening has a curved surface;
c. The opening of the target frame is on top of an elevation, wherein the surface of the elevation surrounding the opening is the contact zone.

Preferably, all features a. to c. are applied in combination.

Particularly preferably the opening on the top of the elevation is a through hole.

Also this design of the target frame is advantageous with regard to the placement of the free-standing membranes. When using the at least one carrier frame to place the layers, the free-standing membranes have to get into a direct contact with the support. The contact zone with the curved surface facilitates this alignment and direct contact. The free-standing membranes, which are usually essentially planar, can be placed on the top of the elevation, thereby spanning the opening on its top and contacting the contact zone.

In line with this, the method according to the invention comprises in preferred embodiments at least one of the following additional features a. to c., preferably all features a. to c.:
a. For placing the first 2D layer onto the support, one side of the layer is attached to a carrier frame (one of the at least one carrier frames), such that the 2D layer spans the opening of this frame, and
b. the other side of the first 2D layer, which is not attached to this carrier frame, is brought into contact with the target frame, such that the first 2D layer attaches to the target frame, preferably to the contact zone of the target frame, thereby spanning the first opening, and
c. a first part of the first 2D layer which is in direct contact with the carrier frame is detached from a second part of the first 2D layer which is in direct contact with the target frame.

In further particularly preferred embodiments, the method according to the invention comprises at least one of the following additional features a. to d., preferably all features a. to c., more preferably all features a. to d.:
a. For placing the second 2D layer onto the previously placed first 2D layer, one side of the layer is attached to a carrier frame (one of the at least one carrier frames), such that the 2D layer spans the opening of this frame, and
b. the other side of the second 2D layer, which is not attached to the carrier frame, is brought into contact with the first 2D layer on the target frame, such that the second 2D layer spans the opening of the target frame and attaches to the first 2D layer, and
c. a first part of the second 2D layer which is in direct contact with carrier frame is detached from a second part of the second 2D layer which attaches to the first 2D layer; and
d. optionally, repeating the preceding steps a. to c. with one or more further 2D layers.

From the above it becomes clear, that the outer form of a 3D van-der-Waals multilayer structure created according to the invention does not primarily depend from the geometry of the 2D layers which are placed on the support. Much more important in this regard are the geometry of the frames. After the first 2D layer has been brought into contact with the target frame, one side of the layer is attached to the target frame wherein the other side is still attached to the carrier frame. Or in other words, the membrane is simultaneously in contact with both frames along contact zones which depend on the geometry of the frames (For example, if both frames have a ring-shaped geometry, the contact zones can form concentric circles). During detachment, the membrane usually breaks between these contact zones. The same effect applies during placement of the second and optional further membranes. In these cases one side of the placed layers is attached to the carrier frame and the other side is attached to the previously placed membrane. During detachment, the membrane usually breaks between a zone of contact with the carrier frame and a further zone of contact to a previously placed membrane. Thus, the form of the frames influences the geometry of the base area of the 3D van-der-Waals multilayer structure and of all 2D layers in the stack.

Surprisingly, the inventors found that the detachment can be effectively achieved by simply moving the frames laterally relative to each other. Preferably, the detachment is achieved by a slightly sideways movement of the carrier frame.

In accordance with this lateral movement, the detachment of the free-standing membranes from the at least one carrier frame is preferably achieved as follows:
a. The detachment of the first part of the first and/or second 2D layer which is in direct contact with the carrier frame is achieved by moving the target frame and/or the carrier frame, preferably by moving the carrier frame;
b. The detachment of the first part of the first and/or second 2D layer which is in direct contact with the carrier frame is achieved by moving the target frame and/or the carrier frame, preferably by moving the carrier frame, in a lateral direction.

In especially preferred embodiments the aforementioned features a. and b. are realized in combination.

Optionally, the line along which the 2D layer breaks during detachment can be further controlled by introducing a perforation in the 2D layer. The perforation can be e.g. a sequence of holes, lines or other shapes. The perforation can be introduced around the intended rim of the 2D layer. E.g. the perforation can be introduced by electron beam induced etching (EBIE) or other methods resulting in a local weakening of the 2D layer in a defined pattern.

In especially preferred embodiments of the method according to the invention, the method includes a structuring respectively pre-patterning of the 2D layers prior to assembling of the 2D layers. Accordingly, the method according to the invention can comprise at least one of the following additional features:
a. Providing the at least two of the 2D layers comprises structuring of at least one of the 2D layers;
b. The structuring of the at least one of the 2D layers is done prior to its placement onto the support or onto a previously placed 2D layer;
c. The structuring of the at least one of the 2D layers is done by a focused electron beam (FEB);
d. The structuring of the at least one of the 2D layers is done by a focused ion beam milling (FIB milling);
e. The structuring of the at least one of the 2D layers is done by electron beam induced etching (EBIE);
f. The structuring of the at least one of the 2D layers is done by ion beam induced etching (IBIE);
g. The structuring of the at least one of the 2D layers is done by an electron beam in transmission electron microscopy or scanning transmission electron microscopy, preferably in the presence of water vapor;
h. The structuring of the at least one of the 2D layers is done at an elevated temperature and/or at ultra-high vacuum.

In especially preferred embodiments features a. and b, are realized in combination with at least one of features c. to h..

The possibility of structuring of the 2D layers, especially of nanostructuring the 2D layers, prior to the stacking respectively placing, provides some important advantages. As a main advantage, much higher resolution can be achieved if 2D materials are provided as free-standing membranes during structuring compared to supported membranes as they are used in prior art assembling methods. In particular, the direct cutting of graphene or other 2D materials by focused electron or ion beam e.g. in a transmission electron microscope (TEM), scanning transmission electron microscope (STEM), or scanning electron microscope (SEM) makes it possible to define feature sizes in the nanometer range resulting in a nanostructuring of the 2D layers. According to the invention, cutting or otherwise modifying 2D materials by electron beam induced etching (EBIE), ion beam induced etching (IBIE), or other methods like focused electron beam milling (FEB) or focused ion beam milling (FIB) is advantageously done with free-standing membranes respectively free-standing 2D layers, where it may ultimately enable a true atomic-level control. This is only possible with free-standing membranes respectively free-standing 2D layers and not with full-surface supported layers as in prior art assembling processes.

EBIE and IBIE are subtractive techniques which can be used to remove material from a surface with a spatial resolution in the order of nanometers. A nozzle (or other dosing device) is used to administer a gas-phase precursor substance to said surface, where it undergoes a highly localized interaction with a focused electron beam (FEB) or ion beam (FIB) in such a manner as to cause etching of the surface in the zone of interaction. Said precursor substance may be the water vapor mentioned above.

FEB milling and FIB milling are other subtractive techniques, which can be used to cause localized ablation/sputtering of material from a sample surface, again with a very high (lateral) spatial resolution. Here, the material removal mechanism is essentially physical rather than chemical in nature.

While EBIE has less spatial resolution than sputtering as done with FEB milling at high voltages, it requires less time for structuring larger areas. Moreover, it simplifies the process as it can be done in the same device as the stacking and thereby provides some advantages over focused electron irradiation at high voltages.

Further improvements in the process of structuring may be achieved by carrying out the stacking in an ultra-high vacuum SEM, where the residual pressure is below 10⁻⁶ Pascal, and/or structuring the sample at elevated temperature, especially at a temperature in a range of 100 to 1,000 °C. These measures may be very helpful, especially in order to avoid contaminations by unwanted molecules during the process.

The structures or patterns which are formed during the pre-structuring of the free-standing 2D layers prior to stacking may basically have an arbitrary structure. Holes are preferably induced by FEB milling or by FIB milling. Other modifications, for example substitutions of atoms or molecules within a single 2D layer are possible. For example, it is possible, that parts of the 2D layers are substituted by another material or overgrown by another material by e.g. chemical vapor deposition methods or the like.

The approach of the inventors combines the almost-atomic resolution structure defined in free-standing 2D material layers with the assembly of preferably pre-structured layers to van-der-Waals multilayer structures, especially heterostructures. The method according to the invention allows to induce structures into 2D layers with a thickness of one- or few-atom atom layers and to subsequently stack the structured layers on top of each other with a precise lateral alignment. The inventors were able to show that the inventive method repeatedly achieved a precision of 10 nm, although this is probably not a fundamental limitation of the inventive method. The material for each 2D layer can in principle be chosen from the vast repertoire of available 2D materials, which makes it possible to directly create functional devices. The method according to the invention allows further the forming of multilayer structures of 2D layers with different structures and properties. In this way, very complex multilayer structures with complex functions can be produced.

As the target structure is formed layer by layer, the method according to the invention can be categorized as 3D printing.

In particularly preferred embodiments of the method it includes a stabilization of the structures which have been provided by the aforementioned structuring (pre-patterning) of the single 2D layers prior to assembly. The stabilization is especially advantageous because the single 2D layers are free-standing and are separately transferred. Stabilization is particularly advantageous if the 2D layer is at least partially weakened by the structuring.

In accordance with the above, the method according to the invention is preferably characterized by at least one of the following additional features a. to e.:
a. The structure induced by structuring of the at least one of the 2D layers is stabilized before the placing of the at least one of the 2D layers;
b. The stabilization of the structure is done by depositing a stabilizer onto the at least one of the 2D layers;
c. The stabilizer is an amorphous carbon structure, preferably an amorphous carbon layer;
d. The stabilizer is deposited by electron beam induced deposition (EBID), preferably during the process of structuring;
e. The deposition of the stabilizer, especially of the amorphous carbon structure, and/or the structuring is done in a hydrocarbon-containing atmosphere.

In especially preferred embodiments two or more of the aforementioned features are combined.

EBID is an additive technique, which can be used to deposit various materials onto a sample surface with a very high (lateral) spatial resolution (of the order of nanometers) and controllable thickness. Similar to EBEI a nozzle (or other dosing device) is used to administer a gas-phase precursor substance to said surface, where it undergoes a highly localized interaction with a focused electron beam (EDIB) or ion beam (IBID). However, here the interaction causes precipitation/deposition of solid material onto the surface in the zone of interaction. Usually a different precursor substance is used than in the case of EBIE or IBIE.

The aforementioned preferred features a. to e. are based on the finding of the inventors that it is possible to employ conditions during e.g. STEM lithography such that the target material is removed, at the same time a support structure is deposited by electron beam induced deposition (EBID). For example, when using MoS₂ or WSe₂ as a material for the 2D layer, into which small features are written using a e.g. 200 kV electron beam in the STEM, a stabilizing structure is deposited. Especially, if a sufficient amount of hydrocarbons are present e.g. in the residual vacuum of the microscope, the same electron beam that is used to sputter away the e.g. MoS₂ will simultaneously crack the hydrocarbons and deposit a thin amorphous carbon film into and around the holes resulting from the structuring and thereby providing a stabilization of the formed structures (nanopatterns). The resulting patterns may then be integrated into the 3D multilayer structure by the assembly process as described above, wherein the structures of nanopatterned 2D layers are stabilized throughout the whole process and non-contiguous layer structures may easily be integrated.

The stabilizing as described above is especially suited for 2D layers made of transition metal dichalcogenides (TMDs) like e.g. tungsten diselenide (WSe₂) or molybdenum disulfide (MoS₂).

In especially preferred embodiments the inventive method further comprises at least one of the following additional features:
a. The stabilizer is removed after the placing of the 2D layers;
b. The removal of the stabilizer is done by focused electron or ion irradiation, preferably in the presence of water vapor;
c. The removal of the stabilizer is done by electron beam induced etching (EBIE) irradiation, preferably in the presence of water vapor;
d. The removal of the stabilizer is done by ion beam induced etching (IBIE), preferably in the presence of water vapor;
e. The removal of the stabilizer is done by applying an elevated temperature, e.g. in a range of 200 - 2,000 °C, preferably in an oxidizing atmosphere.

The removal of the stabilizer is preferably done after assembly of the 2D layers. It is based on the finding of the inventors that especially amorphous carbon can be removed afterwards by electron beam induced etching (EBIE), especially in an oxidizing atmosphere, and the resulting structure is stable because the 2D layers within the 3D multilayer structure stick to each other via their van-der-Waals interaction.

Preferably, the inventive method comprises at least one of the following features:
a. Placing the 2D layers comprises lateral alignment of the 2D layers with a lateral offset of 10 nm or less;
b. Placing the 2D layers comprises using the structures within the 2D layers as described above, which are induced in the 2D layers by structuring, for lateral alignment.

Preferably, the aforementioned features a. and b. are realized in combination.

An outstanding feature of the method according to the invention is that structuring and assembly of the single 2D layers is possible at very high resolutions. In this context, the inventors achieved a lateral offset of 10 nm or less when aligning the 2D layers during placing in the course of the assembling process.

In especially preferred embodiments, the induced structures (nanopatterns) within the single 2D layers, e.g. the holes which may be comprised within the 2D layers, may be used to assist the lateral alignment. In this context a visual control is particularly advantageous, whereby the visual control in the process according to the invention is made possible by the use of the free-standing 2D layers, which are transparent under the conditions.

The precise alignment in the course of the assembling process according to the invention may be assisted by a use of nanomanipulators as generally used in the field of electron microscopy and, preferably, under visual control with e.g. electron microscopy means. Here, it is again the use of free-standing membranes respectively 2D layers in the invention that makes it possible to apply electron microscopic methods for visual control during the assembly process.

Thus, in especially preferred embodiments of the inventive method it comprises at least one of the following additional features:
a. The process, in particular the placement of the layers, is performed under visual feedback from an electron microscope;
b. The process, in particular the placement of the layers, is performed under vacuum, preferably under ultra-high vacuum;
c. The process, in particular the placement of the layers, is performed by the use of nanomanipulators.

In especially preferred embodiments the aforementioned features a. and c. are combined with each other. More preferably, all features a. to c. are combined.

It is especially advantageous to perform the method according to the invention under visual feedback from an electron microscopy, especially in combination with a use of nanomanipulators. As have been shown by the inventors by these measures it is possible to achieve the very good results especially with respect to lateral alignment and good resolution as shown e.g. in the examples below.

The usage of a vacuum, especially an ultra-high vacuum, during the process is especially helpful for avoidance of contaminants of the surfaces of the 2D layers, especially during to process of structuring. The vacuum atmosphere will remove particulate material which may be produced during surface treatment.

With regard to the 2D layers, the inventive method is preferably characterized by at least one of the following additional features:
a. The 2D layers are one- or few-atomic layers of van-der-Waals bonded layered materials;
b. The 2D layers are made from at least one of the following materials: graphene, hexagonal boron nitride, transition metal dichalcogenides (TMDs), especially tungsten diselenide (WSe₂) and/or molybdenum disulfide (MoS₂), Phosphorene, Mica, silica, MXenes;
c. At least one of the 2D layers is made from graphene;
d. At least one of the 2D layers is made from transition metal dichalcogenides (TMDs);
e. At least one of the 2D layers is made from molybdenum disulfide;
f. At least one of the 2D layers is made from tungsten diselenide;
g. The 2D layers have a thickness in the range from 0.3 to 30 nm;
h. The frames define openings with a diameter in the range of 0.5 to 50 µm.

Preferably, two or more of the aforementioned features a. to g. are combined.

It can be preferred that different materials for the 2D layers are combined with each other. E.g. one single 2D layer may be formed by multiple units, e.g. a combination of graphene and one or more transition metal dichalcogenides like molybdenum disulfide and/or tungsten diselenide are possible. Moreover, in especially preferred embodiments, 2D layers each made from a single material are combined with 2D layers made from another material. Accordingly, suitable materials may be chosen in dependency from the application of the resulting 3D structure as it will become apparent for a person skilled in the art.

As outlined above, the opening of the target frame is preferably smaller than the opening of the carrier frame, e.g. the opening of the carrier frame may have a diameter of about 10 µm and the opening of the target frame may have a diameter of about 1 µm. Of course, the required diameters of the frames may be adapted to the respective multilayer structure to be formed and the planned use of the multilayer structure.

The inventive method enables the fabrication of novel nanostructures and device geometries on the basis of the stacking of 2D layers. In particular, the aligned stacking of pre-patterned 2D layers extends the existing capabilities for in-plane structuring into the third dimension. The inventive method may be applied with a large variety of 2D materials and possibly other thin layers. With respect to stabilization of non-contiguous structures within the 2D layers the preferred embodiment using amorphous carbon layers is especially useful with TMD-layers. The current precision in the lateral alignment of the layers of 10 nm or less is especially advantageous, considering the resolution of the SEM of about 2-3 nm. For further improvement of the resolution further measures can be taken to ensure that the frame(s) and the suspended 2D layer are as parallel as possible prior to the placement.

The invention further comprises an apparatus for preparing van-der-Waals multilayer structures by stacking two-dimensional (2D) layers into three-dimensional (3D) multilayer structures. The apparatus comprises:
a. A support comprising a target frame with an opening, wherein the target frame comprises a contact zone surrounding the opening and wherein the contact zone surrounding the first opening (21) has a curved surface;
b. At least one carrier frame defining an opening for transfer of the layers to the support, wherein the opening of the at least one carrier frame is larger than the opening of the target frame.
c. first and second nanomanipulators for moving and/or manipulating the at least one carrier frame and the target frame, and
d. scanning electron microscopic, transmission electron microscopic, scanning transmission electron microscopic, or scanning ion microscopic means.

Details and advantages of the inventive apparatus have already been explained in the context of the method according to the invention.

The invention further comprises a van-der-Waals multilayer structure which is formed by stacking two-dimensional (2D) layers, wherein the stacked layers are aligned with a lateral offset < 100 nm. The van-der-Waals multilayer structure of the invention is obtainable by a method as described above.

The multilayer structure is generally characterized by an excellent resolution in view of the alignment of the single 2D layers and also in view of the preferred structuring (nanopatterns) of the single 2D layers and, moreover, in view of the alignment between the structures respectively nanopatterns between adjacent 2D layers. As shown by the inventors, it is possibly by the inventive method to achieve a lateral offset below 100 nm. In especially preferred embodiments, the lateral offset is 50 nm or less. In more preferred embodiments, the lateral offset is 10 nm or less.

In further especially preferred embodiments the multilayer structure comprises at least two or more 2D layers which comprise different structures. In this context, it may be provided, for example, that one 2D layer has no structuring and another 2D layer has structuring. In particularly preferred embodiments, however, the multilayer structure has an even more complex structure and comprises three or preferably more 2D layers, each of which may have different structures (nanostructures).

In preferred embodiments the lateral dimensions of the multilayer structure are up to 500 nm, preferably up to 100 nm, in diameter. Nevertheless, depending from the respective application of the multilayer structure, the dimensions may be greater or smaller.

Finally, the invention comprises a device comprising the van-der-Waals multilayer structure as described above. In preferred embodiments the device may be adapted to applications in the field of electronics and/or information processing and/or sensing and/or photo-voltaic and/or nanofluidics and/or optics and/or catalysis and/or medicine. Further details of the device, depending from the respective application, will become apparent for a person skilled in the art.

Further features and advantages of the invention read from the following description of preferred embodiments in connection with the drawings. The individual features can be realized separately or in combination with each other.

In the drawings it is shown:
- Fig. 1: Schematic illustration of the stacking process according to the invention;
- Fig. 2: Illustration of the experimental setup for placing 2D layers onto a target frame under SEM observation;
- Fig. 3: Examples of nanopatterns written into WSe₂ layers;
- Fig. 4: SEM image sequence for placement of one 2D layer according to the inventive method;
- Fig. 5: SEM and TEM images of 2D layer structures prior to stacking and after stacking according to the inventive method;
- Fig. 6: Example of a graphene membrane with perforation around the rim of the membrane; and
- Fig. 7: Schematic illustration of stabilization of structures within the 2D layers according to the inventive method.

### PREFERRED EMBODIMENTS OF THE INVENTION

For exemplary practical implementations of the assembling process of the invention the inventors prepared stacks of patterned Tungsten diselenide (WSe₂), Molybdenum disulfide (MoS₂), and graphene. These 2D material layers were prepared into free-standing membranes, and patterns were written into the membranes.

For writing patterns into the WSe₂ or MoS₂, a 200kV electron beam in a (scanning) transmission electron microscope was used. The rate at which the material is removed is in agreement with a sputtering process (so-called knock-damage).

For graphene, the inventors alternatively used electron beam induced etching (EBIE) for removing material in a controlled pattern. This was done using a 3kV electron beam in a scanning electron microscope in presence of water vapor (see Material and Methods for more details). While EBIE had less spatial resolution than sputtering at high voltages, it required less time for structuring larger areas. Moreover, it simplified the process as it can be done in the same device as the stacking.

### Materials and Methods

**2D materials transfer on TEM grid (corresponding to a carrier frame).** Commercial graphene from Graphenea ("easy transfer" mono-layer graphene) was transferred according to the standard protocol of the manufacturer. First, the water soluble polymer was dissolved in deionized water and the floating sacrificial layer with graphene was fished with the TEM grid (QUANTIFOIL^{®} Holey Carbon Films, type R 10/5 - 10µm large holes with 5µm spacing, grid type gold). The TEM grid represented the at least one carrier frame according to the method according to the invention. After drying in air, annealing was performed for one hour at 150°C on a hot plate. The sacrificial layer was removed in acetone (50°C for 1 hour) and isopropyl alcohol (1 hour).

WSe₂ and MoS₂ were grown by CVD (chemical vapor deposition) on Si/SiO₂ Wafer according to methods known per a skilled person. The TMD flakes were transferred to the TEM grid (same type as above) following the procedure as described in Meyer et al. (Jannik Meyer, Caglar O. Girit, Michael F. Crommie, Alex Zettl: Hydrocarbon lithography on graphene membranes. Applied Physics Letters 92.12 (2008): 123110). In short, the grid was placed on the wafer, aligned to the flake and held under light pressure with the help of a micromanipulator (MM3A-EM, Kleindiek). A small droplet of isopropyl alcohol was added on top and the surface tension of the solvent during evaporation ensured contact between the flake and the perforated support film. After annealing on a hot plate (200°C, 5 min), the silicon oxide of the wafer was etched away in an aqueous solution of potassium hydroxide. Thus, the TEM grid representing a carrier frame according to the invention now carryied the TMD flake detached from the wafer. The sample was then washed in deionized water and isopropyl alcohol and subsequently dried in air.

**2D material patterning.** For patterning the 2D material layers, a probe-side aberration corrected JEOLARM200 or an image-side aberration corrected JEOL ARM200 was used. Both microscopes were operated in STEM Mode at 200 kV for writing the structures. The digital micrograph (DM) software was used for programming and running a script that controlled the beam position such that the desired pattern was written into the membrane. After writing the patterns, initial images were obtained at 200 kV in STEM mode, while avoiding excessive electron doses. Further images were then acquired at 80 kV, using the HRTEM mode (high resolution transmission electron microscopy) on the image-side aberration corrected microscope, or using the STEM mode of the probe-corrected microscope. For cutting TMDs and depositing carbon at the same time, the naturally occurring carbon contamination in the microscope were employed.

Alternatively, graphene was patterned (after transfer to the TEM grid) by gas-assisted electron beam induced etching in a Zeiss Leo XB1540 as described by Sommer et al. (Benedikt Sommer, Jens Sonntag, Arkadius Ganczarczyk, Daniel Braam, Günther Prinz, Axel Lorke, Martin Geller Sommer: Electron-beam induced nano-etching of suspended graphene. Scientific Reports 5.1 (2015): 7781). Water vapor was injected near the graphene surface using the gas-injection system of the FIB-SEM (5-line GIS, Orsay Physics). Using an acceleration voltage of 3 kV, the electron beam was scanned over the pattern to be created. Oxidation of graphene by ionized species of the etching agent formed by the electron beam led to volatile COₓ products which were removed by the vacuum system. Since EBIE could be done in the same SEM as the stacking, this simplifies the process, but the resolution is not as good as patterning by STEM. Removal of the carbon from patterned TMDs was done by EBIE using using water vapor or oxygen.

**Substrate preparation (corresponding to a target frame).** A commercially available lift-out grid (Omniprobe^{®}, copper with 5 posts) was used as substrate and was prepared in order to provide a target frame for the method according to the invention. The outer posts were bent downwards whereas the center post was bent upwards by about 50 µm. Bending was done by hand using a tweezer and observed in a Zeiss Stemi optical microscope.

Further preparation of the center post was performed by focused ion beam milling in a Zeiss Crossbeam Auriga 40. The tip of the post was milled narrower to a width of 20 µm and thinner to 5 µm using an acceleration voltage of 30 kV and a milling current of 10 nA. With a lower current of 500 pA, a 2:5 µm x 2:5 µm hole was milled as viewing window in TEM providing the opening of the target frame.

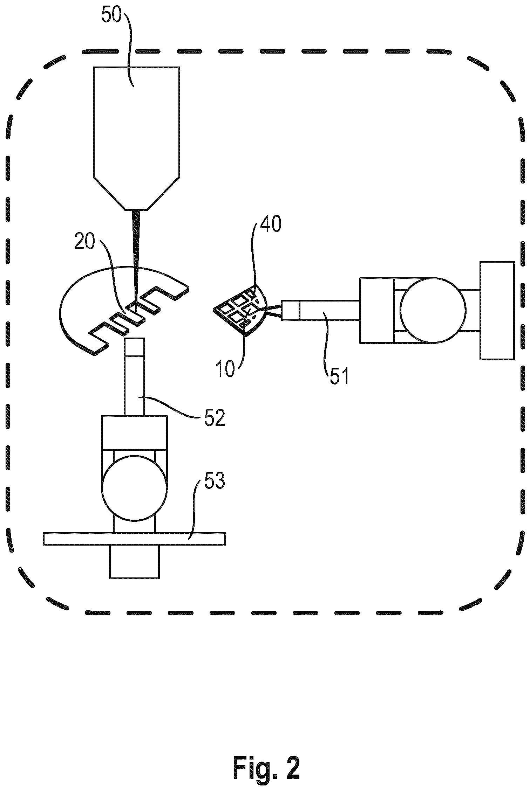

**Stack assembly.** The layer assembly (stacking) was performed in a SEM Zeiss Leo XB1540 equipped with two Kleindiek MM3A-EM nanomanipulators. The TEM grid (corresponding to the carrier frame) carrying the 2D material layer to be stacked was clamped by one of the manipulators, which was mounted horizontally on the SEM stage. The other manipulator was installed vertically and carried the lift-out grid (corresponding to the target frame) for stacking. For accurate stacking, it was helpful that one axis of this manipulator was exactly vertical, i.e., parallel to the electron beam (as shown in Fig. 2, detailed description below). Before loading in the SEM for the assembly, the samples were baked out on a hot plate at 200°C for 10 minutes. Observation of the assembly was performed with an acceleration voltage of 3 kV for the first layer. For additional layers, an acceleration voltage of 10 kV was used. For lateral alignment, the inlens detector was mainly used. For estimating the vertical distance, the secondary electron detector was used.

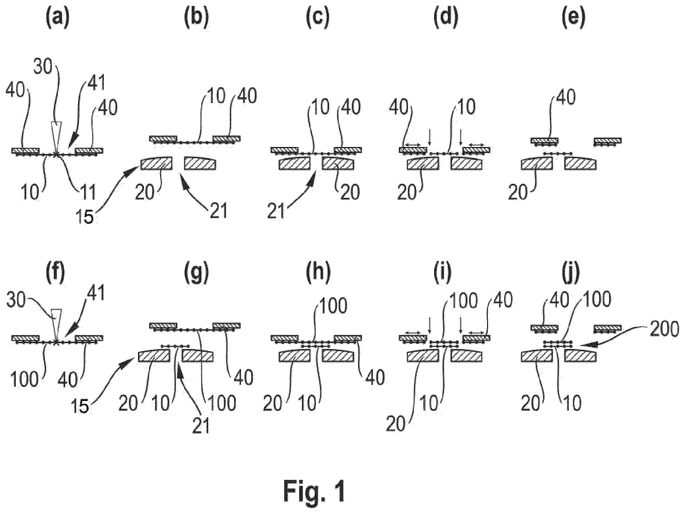

**Fig. 1** shows a schematic illustration of the stacking according to the invention. As shown in **Fig. 1a****,** the process starts with a 2D material layer as a free-standing 2D layer 10, attached to a relatively large carrier frame 40 (e.g. 10 µm diameter). The 2D layer 10 spans a hole respectively opening 41 in the carrier frame 40 (e.g. TEM grid). The 2D layer 10 is patterned by focused electron irradiation 30 (modified area indicated as cross 11). For example, a pattern is written using focused electron irradiation in the (S)TEM or EBIE in the SEM. As shown in **Fig. 1b****+c**, the 2D layer 10 is moved (under SEM observation) along with the carrier frame 40 and is brought into contact with a target frame 20 with a smaller hole respectively opening 21. The surface around the opening 21 is curved to facilitate a contact at the desired area in spite of more or less unavoidable small tilt between the two frames 20 and 40 according to practical reasons in this experimental setup. Upon contact, the 2D layer 10 sticks to the surface of the target frame 20 and spans the opening 21 in the frame 20. The slight curvature of a contact zone surrounding the opening 21 of the target frame 20 facilitates the contact of the surface of the 2D layer 10 at the desired point. As shown in **Fig. 1d****,** lateral motion of the frames 20 and 40 relative to each other (horizontal arrows) leads to a rupture of the 2D layer 10 around the edges of the larger opening 41 of the carrier frame 40 (vertical arrows). Especially by moving the carrier frame 40 slightly sideways, the material breaks off from the carrier frame 40. As shown in **Fig. 1e****,** upon separation of the carrier frame 40, part of the 2D layer 10 stays on the target frame 20. As shown in **Fig. 1f****-j,** the process is repeated with additional 2D layers 100, resulting in a stack 200 of 2D layers.

As a key aspect of the inventive method the individual 2D layers are free-standing prior and during the assembly process, wherein frames defining openings are used in the process enabling structured modifications especially by focused electron irradiation. In especially preferred embodiments the assembly is done with visual feedback from an electron microscope, more preferably it is done in a vacuum using nano-manipulators.

**Fig. 2** illustrates an experimental setup for placing 2D layers onto the target frame 20 under SEM observation 50 in a vacuum chamber. The figure shows the manipulation stages, which are used to carry out the above described stacks (except for patterning individual layers). Individual 2D layers 10 are attached on one-quarter of a TEM grid which represents the carrier frame 40. The target frame 20 is carved out from a lift-out TEM grid. For preparation of the target substrate (frame 20) a single post in a FIB lift-out grid is bent upwards, while the others are bent downwards. The single post is thinned and narrowed by FIB (FIB - focused ion beam), and a hole is inserted thereby providing the target frame 20. Preferably, the hole is made on the curved surface near the end of the post such that a curved contact zone is provided. For maximum flexibility, both the target frame 20 and the carrier frame 40 with the attached 2D layer 10 (suspended, pre-structured 2D layers on the TEM grid) are each held in a nanomanipulator 51 respectively 52. Both manipulators 51, 52 are in addition held by the SEM stage 53 of the electron microscope.

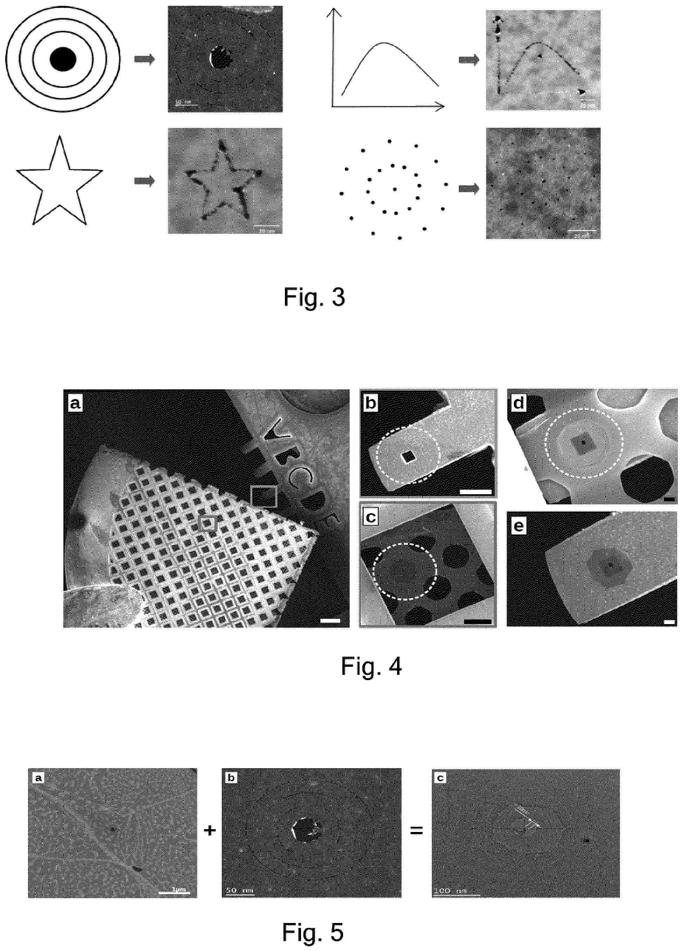

**Fig. 3** shows exemplary structures (nanopatterns) written into 2D layers which are WSe₂ membranes. The structuring was done by the described electron beam methods into the free-standing membranes prior to stacking of the 2D layers according to the described assembly process.

**Fig. 4** shows a SEM image sequence for the placement of one 2D layer with a precise lateral alignment. **Fig. 4a** shows an overview image, showing a quarter of a TEM grid (carrier frame) clamped into a nanomanipulator (left bottom corner) and the target substrate (target frame), a cantilever in a FIB lift-out grid (right) that was further cut into the desired shape by FIB. The target cantilever (target frame) is shown as a close-up in **Fig. 4b. Fig. 4c** shows a close-up of one window in the TEM grid (carrier frame). One of the 10 µm diameter holes in the grid is spanned by a graphene membrane, into which a hole was cut by EBIE with a diameter of about 100 nm. As can be seen in **Fig. 4d** the graphene membrane is brought above the hole in the cantilever, such that the hole in the graphene is centered on the hole in the target substrate, illustrated by the dashed circles in Fig. 4b and Fig. 4c which are made to be approximately overlapping in Fig. 4d. Thereby, the lateral alignment is supported by the structures within the 2D layers. The hole in the cantilever is visible through the graphene membrane. Now, the target substrate is moved upwards (towards the graphene membrane) until a contact is made. The contact can be noticed by a clear change in contrast in the SEM image when the 2D material comes into contact with the target substrate. Now, slight lateral motion of the TEM grid leads to a rupture of the 2D material at the edge of its connection to the TEM grid and breaks off from the TEM grid. Now, the TEM grid can be moved upwards and away from the field of view, leaving the graphene layer and the hole placed into the desired specific location. As shown in **Fig. 4e****,** after removal of the TEM grid, the graphene membrane remains on the cantilever. Scale bars are (a): 100 µm, (b) and (c): 10 µm, (d) and (e): 2 µm.

The process is preferably repeated with further layers for placing additional layers onto the first one in order to assembly a stack of 2D layers according to the inventive process. Since the 2D material layers are semi-transparent in SEM, features in both 2D layers can be observed during placement of a 2D layer, and hence an accurate alignment is possible. While the 2D layers are still at a distance, they can also be distinguished by the difference in focus height of the SEM.

**Fig. 5** illustrates some examples of the layer-by-layer assembly showing SEM and TEM images of layer structures prior to stacking and after stacking. **Fig. 5a** shows a hole in graphene, made by EBIE. **Fig. 5b** shows a central hole and concentric circles in WSe₂, made by sputtering in the STEM. **Fig. 5c** shows a TEM image after aligned placement of the two structures. The offset (distance between the centers of the holes) in this case is about 10 nm.

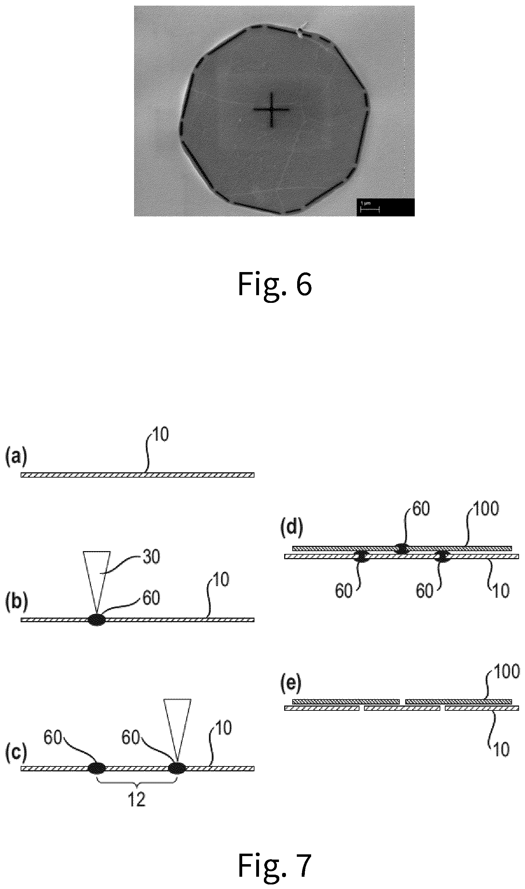

**Fig. 6** shows an example of a graphene membrane where a perforation was introduced around the rim of the membrane. In addition, a cross structure was introduced in the center. The cuts in the membrane were introduced by electron beam induced etching (EBIE). By the perforation around the membrane it is possible to precisely control the membrane breaks during detachment from the support.

**Fig. 7** illustrates the principle for integrating non-contiguous layers by stabilization of the structures in the 2D layers: **Fig. 7a** shows the pristine 2D layer 10. **Fig. 7b****+c** shows that during removal of the layer material by focused electron irradiation 30, a stabilizing material 60 (amorphous carbon) is deposited by EBID within the induced structure of the 2D layer 10. The central part 12 of the structure **(****Fig. 7c****)** is now no longer connected, e.g. if a ring is cut around an isolated dot. **Fig. 7d** shows the assembly of the 2D layers 10 and 100 which are integrated into a stack. As shown in **Fig. 7e****,** the stabilizing material 60 (amorphous carbon) is removed e.g. by EBIE, resulting in a stack of clean, structured 2D layers 10 and 100.

While patterning TMDs in the STEM, it was found by the inventors that it is possible to remove large sections of material (several nanometers in width) around a desired structure that then remains as an island, disconnected from the original lattice and only held in place by amorphous carbon as a stabilizing material.

For removal of the stabilizing material the stack is preferably exposed to an electron beam in presence of water vapor to carry out the EBIE. It was found by the inventors that EBIE with water as etchant is highly selective for removing amorphous carbon over MoS₂ and WSe₂ (and further transition metal dichalcogenides - TMDs): Even the same electron exposure in EBIE that removes the about 30 nm thick amorphous carbon support film of the TEM grid leaves a monolayer of the TMD without any visible perturbation.

## Claims

1. A method of forming a three-dimensional (3D) van-der-Waals multilayer structure by stacking two-dimensional (2D) layers (10, 100), comprising:
a. Providing at least two of the 2D layers (10, 100),
b. placing a first of the 2D layers (10) onto a support (15),
c. placing a second of the 2D layers (100) onto the previously placed first 2D layer (10), thereby producing a stack (200) of two layers,
d. optionally, repeating step c. with one or more further of the 2D layers, thereby increasing the height of the stack (200),
**characterized in that**
e. the 2D layers (10, 100) are free-standing membranes,
f. the support (15) comprises or is a target frame (20) defining an opening (21), and
g. the free-standing membranes are placed in such a way that they span the opening (21) of the target frame (20).

2. The method according to claim 1, comprising the following additional features:
a. The support (15) comprises the target frame (20) with the opening (21) as a first frame (20) with a first opening (21).
b. The 2D layers are placed by means of at least one carrier frame (40) defining an opening (41).
c. The first opening (21) is smaller than the opening (41) of the carrier frame (40).

3. The method according to claim 1 or claim 2, comprising at least one of the following additional features:
a. The target frame (20) comprises a contact zone surrounding the first opening (21);
b. The contact zone surrounding the first opening (21) has a curved surface;
c. The first opening (21) is on top of an elevation, wherein the surface of the elevation surrounding the opening is the contact zone.

4. The method according to claim 2 or claim 3, comprising the following additional features:
a. For placing the first 2D layer (10) onto the support (15), one side of the layer is attached to a carrier frame (40), such that the 2D layer (10) spans the opening (41) of this frame (40), and
b. the other side of the first 2D layer (10), which is not attached to the carrier frame (40), is brought into contact with the target frame (20), such that the first 2D layer (10) attaches to the target frame (20), preferably to the contact zone of the target frame (20), thereby spanning the first opening (21), and
c. a first part of the first 2D layer (10) which is in direct contact with the carrier frame (40) is detached from a second part of the first 2D layer (10) which is in direct contact with the target frame (20).

5. The method according to one of claims 2 to 4, comprising the following additional features:
a. For placing the second 2D layer (100) onto the previously placed first 2D layer (10), one side of the layer (100) is attached to a carrier frame (40), such that the 2D layer (100) spans the opening (41) of this frame, and
b. the other side of the second 2D layer (100), which is not attached to the carrier frame (40), is brought into contact with the first 2D layer (10) on the target frame (20), such that the second 2D layer (100) spans the first opening (21) of the target frame (20) and attaches to the first 2D layer (10), and
c. a first part of the second 2D layer (100) which is in direct contact with the carrier frame (40) is detached from a second part of the second 2D layer (100) which attaches to the first 2D layer (10); and
d. optionally, repeating the preceding steps a. to c. with one or more further 2D layers.

6. The method according to claim 4 or claim 5, further comprising at least one of the following additional features:
a. The detachment of the first part of the first and/or second 2D layer (10, 100) which is in direct contact with the carrier frame (40) is achieved by moving the target frame (20) and/or the carrier frame (40), preferably by moving the carrier frame (40);
b. The detachment of the first part of the first and/or second 2D layer (10, 100) which is in direct contact with the carrier frame (40) is achieved by moving the target frame (20) and/or the carrier frame (40), preferably by moving the carrier frame (40), in a lateral direction.

7. The method according to one of the preceding claims or according to the preamble of claim 1, comprising at least one of the following additional features:
a. Providing the at least two of the 2D layers (10, 100) comprises structuring of at least one of the 2D layers;
b. The structuring of the at least one of the 2D layers (10, 100) is done prior to its placement onto the support (15) or onto a previously placed 2D layer;
c. The structuring of the at least one of the 2D layers (10, 100) is done by a focused electron beam (FEB);
d. The structuring of the at least one of the 2D layers (10, 100) is done by a focused ion beam (FIB);
e. The structuring of the at least one of the 2D layers (10, 100) is done by electron beam induced etching (EBIE);
f. The structuring of the at least one of the 2D layers (10, 100) is done by ion beam induced etching (IBIE);
g. The structuring of the at least one of the 2D layers (10, 100) is done by an electron beam in transmission electron microscopy or scanning transmission electron microscopy, preferably in the presence of water vapor;
h. The structuring of the at least one of the 2D layers (10, 100) is done at an elevated temperature and/or at ultra-high vacuum.

8. The method according to claim 7, comprising at least one of the following additional features:
a. The structure induced by structuring of the at least one of the 2D layers (10, 100) is stabilized before the placing of the at least one of the 2D layers;
b. The stabilization of the structure is done by depositing a stabilizer (60) onto the at least one of the 2D layers;
c. The stabilizer (60) is an amorphous carbon structure, preferably an amorphous carbon layer;
d. The stabilizer (60) is deposited by electron beam induced deposition (EBID), preferably during the process of structuring;
e. The deposition of the stabilizer (60), especially of the amorphous carbon structure, and/or the structuring is done in a hydrocarbon-containing atmosphere.

9. The method according to claim 8, comprising at least one of the following additional features:
a. The stabilizer (60) is removed after the placing of the 2D layers;
b. The removal of the stabilizer (60) is done by focused electron or ion irradiation, preferably in the presence of water vapor;
c. The removal of the stabilizer (60) is done by electron beam induced etching (EBIE) irradiation, preferably in the presence of water vapor;
d. The removal of the stabilizer (60) is done by ion beam induced etching (IBIE), preferably in the presence of water vapor;
e. The removal of the stabilizer (60) is done by applying an elevated temperature, preferably in an oxidizing atmosphere.

10. The method according to one of the preceding claims, comprising at least one of the following additional features:
a. Placing the 2D layers (10, 100) comprises lateral alignment of the 2D layers with a lateral offset of 10 nm or less;
b. Placing the 2D layers (10, 100) comprises using the structures according to one of claims 7 to 9, which are induced in the 2D layers by structuring, for lateral alignment.

11. The method of one of the preceding claims, comprising at least one of the following additional features:
a. The process, in particular the placement of the layers, is performed under visual feedback from an electron microscope;
b. The process, in particular the placement of the layers, is performed under vacuum, preferably under ultra-high vacuum;
c. The process, in particular the placement of the layers, is performed by the use of nanomanipulators (51, 52).

12. The method according to one of the preceding claims, comprising at least one of the following additional features:
a. The 2D layers (10, 100) are one- or few-atomic layers of van-der-Waals bonded layered materials;
b. The 2D layers (10, 100) are made from at least one of the following materials: graphene, hexagonal boron nitride, transition metal dichalcogenides (TMDs), especially tungsten diselenide (WSe₂) and/or molybdenum disulfide (MoS₂), Phosphorene, Mica, silica, MXenes;
c. At least one of the 2D layers (10, 100) is made from graphene;
d. At least one of the 2D layers (10, 100) is made from transition metal dichalcogenides (TMDs);
e. At least one of the 2D layers (10, 100) is made from molybdenum disulfide;
f. At least one of the 2D layers (10, 100) is made from tungsten diselenide;
g. The 2D layers (10, 100) have a thickness in the range from 0.3 to 30 nm;
h. The frames (20, 40) define an opening (21, 41) with a diameter in the range of 0.5 to 50 µm.

13. An apparatus for preparing van-der-Waals multilayer structures by stacking two-dimensional (2D) layers into three-dimensional (3D) multilayer structures, comprising
a. a support (15) comprising a target frame (20) with an opening (21), wherein the target frame (20) comprises a contact zone surrounding the opening (21),
b. at least one carrier frame (40) defining an opening (41) for transfer of the layers to the support (15), wherein the opening (41) of the at least one carrier frame (40) is larger than the opening (21) of the target frame (20),
c. first and second nanomanipulators (51, 52) for moving and/or manipulating the target frame (20) and the carrier frame (40), and
d. scanning electron microscopic, transmission electron microscopic, scanning transmission electron microscopic, or scanning ion microscopic means (50),
**characterized in that** the contact zone surrounding the first opening (21) has a curved surface.

14. A van-der-Waals multilayer structure (200) which is formed by stacking two-dimensional (2D) layers (10, 100), obtained by a method according to any one of claims 1 to 12, **characterized in that** the stacked layers are aligned with a lateral offset < 100 nm.

15. A device comprising a van-der-Waals multilayer structure of claim 14.

## Patentansprüche

1. Verfahren zum Ausbilden einer dreidimensionalen (3D) Van-der-Waals-Mehrschichtstruktur durch Stapeln zweidimensionaler (2D) Schichten (10, 100), umfassend:
a. Bereitstellen von mindestens zwei der 2D-Schichten (10, 100),
b. Anordnen einer ersten der 2D-Schichten (10) auf einem Träger (15),
c. Anordnen einer zweiten der 2D-Schichten (100) auf der zuvor angeordneten ersten 2D-Schicht (10), wodurch ein Stapel (200) aus zwei Schichten erzeugt wird,
d. optional Wiederholen von Schritt c. mit einer oder mehreren weiteren der 2D-Schichten, wodurch die Höhe des Stapels (200) erhöht wird,
**dadurch gekennzeichnet, dass**
e. die 2D-Schichten (10, 100) freistehende Membranen sind,
f. der Träger (15) einen Zielrahmen (20), der eine Öffnung (21) definiert, umfasst oder ein solcher ist, und
g. die freistehenden Membranen derart angeordnet werden, dass sie die Öffnung (21) des Zielrahmens (20) überspannen.

2. Verfahren nach Anspruch 1, umfassend die folgenden zusätzlichen Merkmale:
a. Der Träger (15) umfasst den Zielrahmen (20) mit der Öffnung (21) als einen ersten Rahmen (20) mit einer ersten Öffnung (21)
b. Die 2D-Schichten werden mittels mindestens eines Trägerrahmens (40), der eine Öffnung (41) definiert, angeordnet
c. Die erste Öffnung (21) ist kleiner als die Öffnung (41) des Trägerrahmens (40).

3. Verfahren nach Anspruch 1 oder Anspruch 2, umfassend mindestens eines der folgenden zusätzlichen Merkmale:
a. Der Zielrahmen (20) umfasst eine Kontaktzone, die die erste Öffnung (21) umgibt;
b. Die die erste Öffnung (21) umgebende Kontaktzone weist eine gekrümmte Oberfläche auf;
c. Die erste Öffnung (21) befindet sich auf einer Erhöhung, wobei die die Öffnung umgebende Oberfläche der Erhöhung die Kontaktzone ist.

4. Verfahren nach Anspruch 2 oder Anspruch 3, umfassend die folgenden zusätzlichen Merkmale:
a. Zum Anordnen der ersten 2D-Schicht (10) auf dem Träger (15) wird eine Seite der Schicht derart an einen Trägerrahmen (40) gefügt, dass die 2D-Schicht (10) die Öffnung (41) dieses Rahmens (40) überspannt, und
b. die andere Seite der ersten 2D-Schicht (10), die nicht an den Trägerrahmen (40) gefügt ist, wird derart mit dem Zielrahmen (20) in Kontakt gebracht, dass sich die erste 2D-Schicht (10) an den Zielrahmen (20), vorzugsweise an die Kontaktzone des Zielrahmens (20), fügt, wodurch die erste Öffnung (21) überspannt wird, und
c. ein erster Teil der ersten 2D-Schicht (10), der sich in direktem Kontakt mit dem Trägerrahmen (40) befindet, wird von einem zweiten Teil der ersten 2D-Schicht (10), der sich in direktem Kontakt mit dem Zielrahmen (20) befindet, gelöst.

5. Verfahren nach einem der Ansprüche 2 bis 4, umfassend die folgenden zusätzlichen Merkmale:
a. Zum Anordnen der zweiten 2D-Schicht (100) auf der zuvor angeordneten ersten 2D-Schicht (10) wird eine Seite der Schicht (100) derart an einen Trägerrahmen (40) gefügt, dass die 2D-Schicht (100) die Öffnung (41) dieses Rahmens überspannt, und
b. die andere Seite der zweiten 2D-Schicht (100), die nicht an den Trägerrahmen (40) gefügt ist, wird mit der ersten 2D-Schicht (10) auf dem Zielrahmen (20) derart in Kontakt gebracht, dass die zweite 2D-Schicht (100) die erste Öffnung (21) des Zielrahmens (20) überspannt und sich an die erste 2D-Schicht (10) fügt, und
c. ein erster Teil der zweiten 2D-Schicht (100), der mit dem Trägerrahmen (40) in direktem Kontakt steht, wird von einem zweiten Teil der zweiten 2D-Schicht (100) gelöst, der sich an die erste 2D-Schicht (10) fügt; und
d. optional Wiederholen der vorhergehenden Schritte a. bis c. mit einer oder mehreren weiteren 2D-Schichten.

6. Verfahren nach Anspruch 4 oder Anspruch 5, ferner umfassend mindestens eines der folgenden zusätzlichen Merkmale:
a. Die Ablösung des ersten Teils der ersten und/oder zweiten 2D-Schicht (10, 100), der sich in direktem Kontakt mit dem Trägerrahmen (40) befindet, wird durch Bewegen des Zielrahmens (20) und/oder des Trägerrahmens (40), vorzugsweise durch Bewegen des Trägerrahmens (40), erreicht;
b. Die Ablösung des ersten Teils der ersten und/oder zweiten 2D-Schicht (10, 100), der sich in direktem Kontakt mit dem Trägerrahmen (40) befindet, wird durch Bewegen des Zielrahmens (20) und/oder des Trägerrahmens (40), vorzugsweise durch Bewegen des Trägerrahmens (40), in einer lateralen Richtung erreicht.

7. Verfahren nach einem der vorhergehenden Ansprüche oder nach dem Oberbegriff von Anspruch 1, umfassend mindestens eines der folgenden zusätzlichen Merkmale:
a. Bereitstellen der mindestens zwei der 2D-Schichten (10, 100) umfasst Strukturieren mindestens einer der 2D-Schichten;
b. Das Strukturieren der mindestens einen der 2D-Schichten (10, 100) erfolgt vor Anordnung derselben auf dem Träger (15) oder auf einer zuvor angeordneten 2D-Schicht;
c. Das Strukturieren der mindestens einen der 2D-Schichten (10, 100) erfolgt durch einen gebündelten Elektronenstrahl (FEB);
d. Das Strukturieren der mindestens einen der 2D-Schichten (10, 100) erfolgt durch einen gebündelten Ionenstrahl (FIB);
e. Das Strukturieren der mindestens einen der 2D-Schichten (10, 100) erfolgt durch elektronenstrahlinduziertes Ätzen (EBIE);
f. Das Strukturieren der mindestens einen der 2D-Schichten (10, 100) erfolgt durch ionenstrahlinduziertes Ätzen (IBIE);
g. Das Strukturieren der mindestens einen der 2D-Schichten (10, 100) erfolgt durch einen Elektronenstrahl in einer Transmissionselektronenmikroskopie oder Rastertransmissionselektronenmikroskopie, vorzugsweise in Anwesenheit von Wasserdampf;
h. Das Strukturieren der mindestens einen der 2D-Schichten (10, 100) erfolgt bei einer erhöhten Temperatur und/oder bei Ultrahochvakuum.

8. Verfahren nach Anspruch 7, umfassend mindestens eines der folgenden zusätzlichen Merkmale:
a. Die durch Strukturieren der mindestens einen der 2D-Schichten (10, 100) induzierte Struktur wird vor dem Anordnen der mindestens einen der 2D-Schichten stabilisiert;
b. Die Stabilisierung der Struktur erfolgt durch Abscheiden eines Stabilisators (60) auf die mindestens eine der 2D-Schichten;
c. Der Stabilisator (60) ist eine amorphe Kohlenstoffstruktur, vorzugsweise eine amorphe Kohlenstoffschicht;
d. Der Stabilisator (60) wird durch elektronenstrahlinduzierte Abscheidung (EBID), vorzugsweise während des Prozesses zum Strukturieren, abgeschieden;
e. Die Abscheidung des Stabilisators (60), insbesondere der amorphen Kohlenstoffstruktur, und/oder das Strukturieren erfolgt in einer kohlenwasserstoffhaltigen Atmosphäre.

9. Verfahren nach Anspruch 8, umfassend mindestens eines der folgenden zusätzlichen Merkmale
a. Der Stabilisator (60) wird nach dem Anordnen der 2D-Schichten entfernt;
b. Die Entfernung des Stabilisators (60) erfolgt durch gebündelte Elektronen- oder Ionenbestrahlung, vorzugsweise in Anwesenheit von Wasserdampf;
c. Die Entfernung des Stabilisators (60) erfolgt durch elektronenstrahlinduzierte Ätz(EBIE)-Bestrahlung, vorzugsweise in Anwesenheit von Wasserdampf;
d. Die Entfernung des Stabilisators (60) erfolgt durch ionenstrahlinduziertes Ätzen (IBIE), vorzugsweise in Anwesenheit von Wasserdampf;
e. Die Entfernung des Stabilisators (60) erfolgt durch Aufbringen einer erhöhten Temperatur, vorzugsweise in einer oxidierenden Atmosphäre.

10. Verfahren nach einem der vorhergehenden Ansprüche, umfassend mindestens eines der folgenden zusätzlichen Merkmale:
a. Anordnen der 2D-Schichten (10, 100) umfasst eine laterale Ausrichtung der 2D-Schichten mit einem lateralen Versatz von 10 nm oder weniger;
b. Anordnen der 2D-Schichten (10, 100) umfasst Verwenden der Strukturen nach einem der Ansprüche 7 bis 9, die in den 2D-Schichten durch Strukturieren induziert werden, zur lateralen Ausrichtung.

11. Verfahren nach einem der vorhergehenden Ansprüche, umfassend mindestens eines der folgenden zusätzlichen Merkmale:
a. Der Prozess, insbesondere die Anordnung der Schichten, wird unter visueller Rückkopplung von einem Elektronmikroskop durchgeführt;
b. Der Prozess, insbesondere die Anordnung der Schichten, wird bei Unterdruck, vorzugsweise bei Ultrahochunterdruck, durchgeführt;
c. Der Prozess, insbesondere die Anordnung der Schichten, wird unter Verwendung von Nanomanipulatoren (51, 52) durchgeführt.

12. Verfahren nach einem der vorhergehenden Ansprüche, umfassend mindestens eines der folgenden zusätzlichen Merkmale:
a. Die 2D-Schichten (10, 100) sind ein- oder mehratomige Schichten aus van-der-Waals-gebondeten geschichteten Materialien;
b. Die 2D-Schichten (10, 100) bestehen aus mindestens einem der folgenden Materialien: Graphen, hexagonales Bornitrid, Übergangsmetalldichalkogenide (TMDs), insbesondere Wolframdiselenid (WSe₂) und/oder Molybdändisulfid (MoS₂), Phosphoren, Glimmer, Siliciumdioxid, MXene;
c. Mindestens eine der 2D-Schichten (10, 100) besteht aus Graphen;
d. Mindestens eine der 2D-Schichten (10, 100) besteht aus Übergangsmetalldichalkogeniden (TMDs);
e. Mindestens eine der 2D-Schichten (10, 100) besteht aus Molybdändisulfid;
f. Mindestens eine der 2D-Schichten (10, 100) besteht aus Wolframdiselenid;
g. Die 2D-Schichten (10, 100) weisen eine Dicke im Bereich von 0,3 bis 30 nm auf;
h. Die Rahmen (20, 40) definieren eine Öffnung (21, 41) mit einem Durchmesser im Bereich von 0,5 bis 50 µm.

13. Einrichtung zum Erstellen von Van-der-Waals-Mehrschichtstrukturen durch Stapeln zweidimensionaler (2D) Schichten in dreidimensionale (3D) Mehrschichtstrukturen, umfassend
a. einen Träger (15), der einen Zielrahmen (20) mit einer Öffnung (21) umfasst, wobei der Zielrahmen (20) eine die Öffnung (21) umgebende Kontaktzone umfasst,
b. mindestens einen Trägerrahmen (40), der eine Öffnung (41) zum Transfer der Schichten auf den Träger (15) definiert, wobei die Öffnung (41) des mindestens einen Trägerrahmens (40) größer als die Öffnung (21) des Zielrahmens (20) ist,
c. erste und zweite Nanomanipulatoren (51, 52) zum Bewegen und/oder Manipulieren des Zielrahmens (20) und des Trägerrahmens (40), und
d. rasterelektronenmikroskopische, transmissionselektronenmikroskopische, rastertransmissionselektronenmikroskopische oder rasterionenmikroskopische Mittel (50),
**dadurch gekennzeichnet, dass** die die erste Öffnung (21) umgebende Kontaktzone eine gekrümmte Oberfläche aufweist.

14. Van-der-Waals-Mehrschichtstruktur (200), die durch Stapeln zweidimensionaler (2D) Schichten (10, 100) gebildet wird, die durch ein Verfahren nach einem der Ansprüche 1 bis 12 erhalten werden, **dadurch gekennzeichnet, dass** die gestapelten Schichten mit einem lateralen Versatz < 100 nm ausgerichtet sind.

15. Vorrichtung, umfassend eine Van-der-Waals-Mehrschichtstruktur nach Anspruch 14.

## Revendications

1. Procédé de formation d'une structure multicouche de van der Waals à trois dimensions (3D) par empilement de couches à deux dimensions (2D) (10, 100), comprenant les étapes suivantes :
a. fourniture d'au moins deux des couches 2D (10, 100),
b. mise en place d'une première des couches 2D (10) sur un support (15),
c. mise en place d'une deuxième des couches 2D (100) sur la première couche 2D (10) précédemment mise en place, de manière à produire une pile (200) de deux couches,
d. facultativement, répétition de l'étape c. avec une ou plusieurs autres des couches 2D, de manière à augmenter la hauteur de la pile (200),
**caractérisé en ce que**
e. les couches 2D (10, 100) sont des membranes auto-supportées,
f. le support (15) comprend ou constitue un cadre cible (20) définissant une ouverture (21), et
g. les membranes auto-supportées sont mises en place de façon à enjamber l'ouverture (21) du cadre cible (20).

2. Procédé selon la revendication 1, comprenant les caractéristiques supplémentaires suivantes :
a. le support (15) comprend le cadre cible (20) muni de l'ouverture (21) formant un premier cadre (20) muni d'une première ouverture (21),
b. les couches 2D sont mises en place au moyen d'au moins un cadre porteur (40) définissant une ouverture (41),
c. la première ouverture (21) est plus petite que l'ouverture (41) du cadre porteur (40).

3. Procédé selon la revendication 1 ou la revendication 2, comprenant au moins une des caractéristiques supplémentaires suivantes :
a. le cadre cible (20) comprend une zone de contact entourant la première ouverture (21) ;
b. la zone de contact entourant la première ouverture (21) est pourvue d'une surface incurvée ;
c. la première ouverture (21) est au sommet d'une surélévation, la surface de la surélévation entourant l'ouverture constituant la zone de contact.

4. Procédé selon la revendication 2 ou la revendication 3, comprenant les caractéristiques supplémentaires suivantes :
a. pour la mise en place de la première couche 2D (10) sur le support (15), un côté de la couche est attaché à un cadre porteur (40), de sorte que la couche 2D (10) enjambe l'ouverture (41) de ce cadre (40), et
b. l'autre côté de la première couche 2D (10), qui n'est pas attaché au cadre porteur (40), est amené au contact du cadre cible (20), de sorte que la première couche 2D (10) s'attache au cadre cible (20), de préférence à la zone de contact du cadre cible (20), de manière à enjamber la première ouverture (21), et
c. une première partie de la première couche 2D (10) qui est au contact direct du cadre porteur (40) est détachée d'une deuxième partie de la première couche 2D (10) qui est au contact direct du cadre cible (20).

5. Procédé selon l'une des revendications 2 à 4, comprenant les caractéristiques supplémentaires suivantes :
a. pour la mise en place de la deuxième couche 2D (100) sur la première couche 2D (10) précédemment mise en place, un côté de la couche (100) est attaché à un cadre porteur (40), de sorte que la couche 2D (100) enjambe l'ouverture (41) de ce cadre, et
b. l'autre côté de la deuxième couche 2D (100), qui n'est pas attaché au cadre porteur (40), est amené au contact de la première couche 2D (10) sur le cadre cible (20), de sorte que la deuxième couche 2D (100) enjambe la première ouverture (21) du cadre cible (20) et s'attache à la première couche 2D (10), et
c. une première partie de la deuxième couche 2D (100) qui est au contact direct du cadre porteur (40) est détachée d'une deuxième partie de la deuxième couche 2D (100) qui s'attache à la première couche 2D (10) ; et
d. facultativement, répétition des étapes a. à c. précédentes avec une ou plusieurs autres couches 2D.

6. Procédé selon la revendication 4 ou la revendication 5, comprenant en outre au moins une des caractéristiques supplémentaires suivantes :
a. le détachement de la première partie de la première et/ou de la deuxième couche 2D (10, 100) qui est au contact direct du cadre porteur (40) s'obtient par déplacement du cadre cible (20) et/ou du cadre porteur (40), de préférence par déplacement du cadre porteur (40) ;
b. le détachement de la première partie de la première et/ou de la deuxième couche 2D (10, 100) qui est au contact direct du cadre porteur (40) s'obtient par déplacement du cadre cible (20) et/ou du cadre porteur (40), de préférence par déplacement du cadre porteur (40), dans une direction latérale.

7. Procédé selon l'une des revendications précédentes ou selon le préambule de la revendication 1, comprenant au moins une des caractéristiques supplémentaires suivantes :
a. la fourniture des au moins deux des couches 2D (10, 100) comprend la structuration d'au moins une des couches 2D ;
b. la structuration de l'au moins une des couches 2D (10, 100) s'effectue préalablement à sa mise en place sur le support (15) ou sur une couche 2D précédemment mise en place ;
c. la structuration de l'au moins une des couches 2D (10, 100) s'effectue par un faisceau d'électrons focalisé (FEB) ;
d. la structuration de l'au moins une des couches 2D (10, 100) s'effectue par un faisceau d'ions focalisé (FIB) ;
e. la structuration de l'au moins une des couches 2D (10, 100) s'effectue par gravure induite par un faisceau d'électrons (EBIE) ;
f. la structuration de l'au moins une des couches 2D (10, 100) s'effectue par gravure induite par un faisceau d'ions (IBIE) ;
g. la structuration de l'au moins une des couches 2D (10, 100) s'effectue par un faisceau d'électrons en microscopie électronique en transmission ou en microscopie électronique en transmission à balayage, de préférence en présence de vapeur d'eau ;
h. la structuration de l'au moins une des couches 2D (10, 100) s'effectue à température élevée et/ou sous ultravide.

8. Procédé selon la revendication 7, comprenant au moins une des caractéristiques supplémentaires suivantes :
a. la structure induite par structuration de l'au moins une des couches 2D (10, 100) est stabilisée avant la mise en place de l'au moins une des couches 2D ;
b. la stabilisation de la structure s'effectue par dépôt d'un stabilisateur (60) sur l'au moins une des couches 2D ;
c. le stabilisateur (60) est une structure en carbone amorphe, de préférence une couche de carbone amorphe ;
d. le stabilisateur (60) est déposé par dépôt induit par un faisceau d'électrons (EBID), de préférence au cours du processus de structuration ;
e. le dépôt du stabilisateur (60), plus particulièrement de la structure en carbone amorphe, et/ou la structuration s'effectuent/s'effectue sous une atmosphère contenant des hydrocarbures.

9. Procédé selon la revendication 8, comprenant au moins une des caractéristiques supplémentaires suivantes :
a. le stabilisateur (60) est éliminé après la mise en place des couches 2D ;
b. l'élimination du stabilisateur (60) s'effectue par exposition à un rayonnement d'électrons ou d'ions focalisé, de préférence en présence de vapeur d'eau ;
c. l'élimination du stabilisateur (60) s'effectue par exposition à un rayonnement de gravure induite par un faisceau d'électrons (EBIE), de préférence en présence de vapeur d'eau ;
d. l'élimination du stabilisateur (60) s'effectue par gravure induite par un faisceau d'ions (IBIE), de préférence en présence de vapeur d'eau ;
e. l'élimination du stabilisateur (60) s'effectue par application d'une température élevée, de préférence sous atmosphère oxydante.

10. Procédé selon l'une des revendications précédentes, comprenant au moins une des caractéristiques supplémentaires suivantes :
a. la mise en place des couches 2D (10, 100) comprend l'alignement latéral des couches 2D avec un décalage latéral inférieur ou égal à 10 nm ;
b. la mise en place des couches 2D (10, 100) comprend l'utilisation des structures selon l'une des revendications 7 à 9, qui sont induites dans les couches 2D par structuration, pour l'alignement latéral.

11. Procédé selon l'une des revendications précédentes, comprenant au moins une des caractéristiques supplémentaires suivantes :
a. le processus, notamment la mise en place des couches, est réalisé sous retour visuel à partir d'un microscope électronique ;
b. le processus, notamment la mise en place des couches, est réalisé sous vide, de préférence sous ultravide ;
c. le processus, notamment la mise en place des couches, est réalisé à l'aide de nanomanipulateurs (51, 52).

12. Procédé selon l'une des revendications précédentes, comprenant au moins une des caractéristiques supplémentaires suivantes :
a. les couches 2D (10, 100) sont une ou quelques couches atomiques de matériaux en couches à liaison de van der Waals ;
b. les couches 2D (10, 100) sont composées d'au moins un des matériaux suivants : le graphène, le nitrure de bore hexagonal, les dichalcogénures de métaux de transition (TMD), plus particulièrement le diséléniure de tungstène (WSe₂) et/ou le disulfure de molybdène (MoS₂), le phosphorène, le mica, la silice, les MXenes ;
c. au moins une des couches 2D (10, 100) est composée de graphène ;
d. au moins une des couches 2D (10, 100) est composée de dichalcogénures de métaux de transition (TMD) ;
e. au moins une des couches 2D (10, 100) est composée de disulfure de molybdène ;
f. au moins une des couches 2D (10, 100) est composée de diséléniure de tungstène ;
g. les couches 2D (10, 100) présentent une épaisseur comprise entre 0,3 et 30 nm ;
h. les cadres (20, 40) définissent une ouverture (21, 41) dont le diamètre est compris entre 0,5 et 50 µm.

13. Appareil de préparation de structures multicouches de van der Waals par empilement de couches à deux dimensions (2D) en structures multicouches à trois dimensions (3D), comprenant
a. un support (15) comprenant un cadre cible (20) muni d'une ouverture (21), le cadre cible (20) comprenant une zone de contact entourant l'ouverture (21),
b. au moins un cadre porteur (40) définissant une ouverture (41) pour le transfert des couches vers le support (15), l'ouverture (41) de l'au moins un cadre porteur (40) étant plus grande que l'ouverture (21) du cadre cible (20),
c. des premier et deuxième nanomanipulateurs (51, 52) destinés à déplacer et/ou manipuler le cadre cible (20) et le cadre porteur (40), et
d. des moyens (50) de microscopie électronique à balayage, de microscopie électronique en transmission, de microscopie électronique en transmission à balayage, ou de microscopie ionique à balayage,
**caractérisé en ce que** la zone de contact entourant la première ouverture (21) est pourvue d'une surface incurvée.

14. Structure multicouche de van der Waals (200) formée par empilement de couches à deux dimensions (2D) (10, 100), obtenue par un procédé selon l'une quelconque des revendications 1 à 12, **caractérisée en ce que** les couches empilées sont alignées avec un décalage latéral < 100 nm.

15. Dispositif comprenant une structure multicouche de van der Waals selon la revendication 14.
